Europäisches Patentamt

(19) European Patent Office

Office européen des brevets

(11) EP 0 732 785 A1

(12) EUROPEAN PATENT APPLICATION

(43) Date of publication:
18.09.1996 Bulletin 1996/38

(51) Int. Cl.⁶: **H01S 3/25**, H01S 3/085

(21) Application number: 96103093.9

(22) Date of filing: 29.02.1996

(84) Designated Contracting States:
DE FR GB

(30) Priority: 17.03.1995 JP 58721/95

(71) Applicant: MITSUBISHI DENKI KABUSHIKI
KAISHA
Tokyo 100 (JP)

(72) Inventor: Hisa, Yoshihiro
Chiyoda-ku, Tokyo 100 (JP)

(74) Representative: KUHNEN, WACKER & PARTNER
Alois-Steinecker-Strasse 22
85354 Freising (DE)

(54) **Semiconductor laser device and method of fabricating semiconductor laser device**

(57)    A semiconductor laser device comprises a plurality of distributed feedback semiconductor laser elements (2a,2b,2c,2d,2e) disposed on a semiconductor substrate (1) and each including a resonator (3) having a center axis and a gain-coupled diffraction grating (41), wherein the gain-coupled diffraction gratings (41) are arranged at the same period and in the same direction, and the center axes of the resonators (3) form different angles with the direction perpendicular to the direction of the diffraction gratings (41). Therefore, the wavelengths of light beams oscillated in the respective semiconductor laser elements are varied from each other. Further, even when the diffraction grating with no λ/4-shifted region is employed, the oscillation of laser light in each semiconductor laser element is not adversely affected by the phase change of the laser light due to reflections at the front and rear facets of the resonator, so that a stable single-mode oscillation is easily realized.

Fig.1

## Description

### FIELD OF THE INVENTION

The present invention relates to semiconductor laser devices used for superhigh-speed optical communications, such as wavelength division multiplex optical communications. The invention also relates to methods of fabricating the semiconductor laser devices.

### BACKGROUND OF THE INVENTION

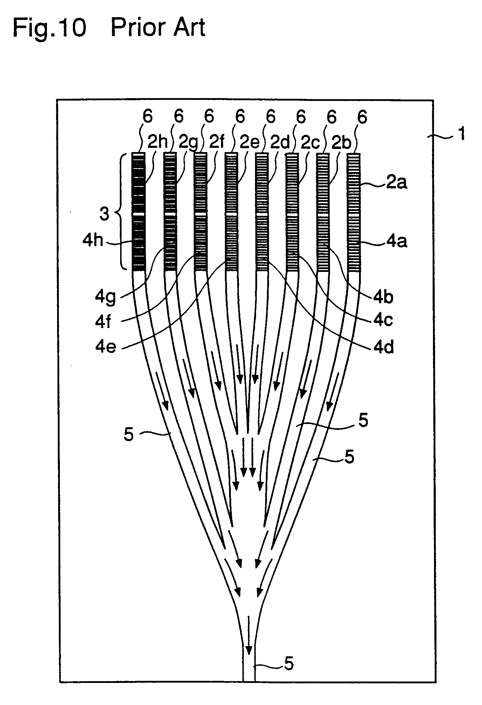

For future communications, a transmission speed of several hundreds of Gbps is demanded in the transmission of large quantities of information, and wavelength division multiplex optical communication systems are promising as optical communication systems that meet the demand. The wavelength division multiplex optical communication system needs a semiconductor laser source that supplies a plurality of laser beams having different wavelengths. Figure 10 is a plan view illustrating a semiconductor laser device used as such semiconductor laser source. In the figure, reference numeral 1 designates a semiconductor substrate, numerals 2a, 2b, 2c, 2d, 2e, 2f, 2g, and 2h (hereinafter referred to as 2a to 2h) designate semiconductor laser elements, numeral 3 designates resonators, numerals 4a, 4b, 4c, 4d, 4e, 4f, 4g, and 4h (hereinafter referred to as 4a to 4h) designate diffraction gratings, numeral 5 designates optical waveguides, and numeral 6 designates reflecting facets. The semiconductor laser elements 2a to 2h have different oscillation wavelengths. Laser beams emitted from the respective semiconductor laser elements 2a to 2h (shown by arrows in figure 10) are collected into one beam by the waveguides 5, whereby the wavelengths of the laser beams are multiplexed, resulting in a laser source that realizes the above-described transmission speed.

Generally, in light sources for use in optical communication systems, a light beam emitted from each semiconductor laser element must have a single wavelength so that the light beam can stand the long-distance transmission. DFB (distributed feedback) lasers are used as the laser elements. As shown in figure 10, the DFB lasers include the diffraction gratings 4a to 4h which are produced in the direction perpendicular to the longitudinal direction of the resonators 3 to select a mode in the resonator length direction. When the diffraction grating is absent, laser oscillation occurs in plural modes that are determined by the energy band structure of crystal constituting the resonator and the length of the resonator, producing a laser light having plural wavelengths. However, when the diffraction grating is present, the diffraction grating selects one of the wavelengths. In this case, the wavelength of the oscillated laser light is represented by

$$\lambda = 2 \times n \times \Lambda \qquad (1)$$

where $\lambda$ is the wavelength of the oscillated light, n is the refractive index of the resonator, and $\Lambda$ is the period of the diffraction grating.

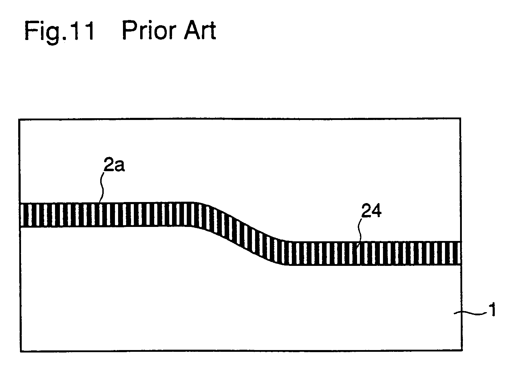

As the diffraction grating for use in DFB lasers, a gain coupled diffraction grating comprising a material that absorbs laser light and a refractive index coupled diffraction grating comprising a material having a refractive index different from refractive indexes of surrounding materials are generally employed. When the gain-coupled diffraction grating is employed, a diffraction grating having regular period and phase over the resonator of the laser is produced. However, when the refractive index coupled diffraction grating is employed, in order to obtain a single mode oscillation without adverse influences of reflections at the front and rear facets of the resonator, the phase of the diffraction grating must be shifted by $\pi$, i.e., 1/2 of the grating period, in the center of the resonator. Since this shifting is identical to 1/4 shifting of the wavelength $\lambda$ of light in the active layer, the phase-shifted region in the diffraction grating is called a $\lambda/4$-shifted region. Because of the phase shifting, the process of transferring the diffraction grating pattern to the semiconductor substrate is a little complicated. Instead of shifting the phase of the diffraction grating on the semiconductor substrate, a center portion of the resonator may be bent as shown in figure 11. Also in this method, the same effect as provided by the phase shifting of the diffraction grating is obtained. In addition, since an ordinary interference exposure method can be applied to the process of transferring the diffraction grating pattern, an inexpensive exposure apparatus can be used for the method and the reliability of the fabricated semiconductor laser device is improved.

In the above-described semiconductor laser devices used in the wavelength division multiplex optical communication systems, when DFB lasers are used as the respective laser elements, in order to vary the oscillation wavelengths of the respective DFB lasers, a method of changing the period $\Lambda$ of the diffraction grating or a method of changing the refractive index n by changing the composition of crystal constituting the resonator are suggested from the formula (1).

In the method of changing the period of the diffraction grating, the period of the diffraction grating as short as 0.2 $\mu$m must be changed in a range shorter than 0.2 $\mu$m. Therefore, only EB (electron beam) direct printing method or X-ray exposure method is applicable to the process of transferring the diffraction grating pattern to the semiconductor substrate. In wavelength division multiplex optical communications, about 1 nm is appropriate for a minimum difference between adjacent, i.e. nearest, two wavelengths. If the active layer comprises InGaAsP, since the refractive index n is 3.400, a difference in the periods of the diffraction gratings corresponding to the difference between the two wavelengths is 0.15 nm from the formula (1). However, when the EB direct printing method is employed, since a minimum step of electron beam of an EB printing apparatus for general use is 10 nm, it is necessary to remodel the EB printing apparatus so that the minimum step is reduced to 0.1 nm, in order to control the oscillation wavelength with the unit of 1 nm. However, such remodeling is technically very difficult. Even though the apparatus is remodeled as described above, in order to shift the period of the diffraction grating between adjacent resonators, a plurality of job files for setting device parameters for printing control are required for each resonator. As a result, the file management and the printing operation using those files are complicated, and the printing time is unfavorably increased. In case of employing the X-ray exposure method, the problem is that the X-ray exposure apparatus is very expensive.

On the other hand, in the method of changing the oscillation wavelength of the laser element by changing the refractive index of crystal constituting the resonator, since it is necessary to change the crystal composition of the resonator, a selective growth technique is employed for the growth of the crystal. In the selective growth technique, insulating masks for the selective growth are formed on the semiconductor substrate sandwiching regions of the substrate where the resonators are later fabricated so that the spacings between the masks sandwiching these regions are different from each other and, thereafter, the crystal for the resonators are grown using the masks, whereby the crystal composition of the resonators is varied due to the different spacings between the masks. However, this selective growth technique is very complicated, and unwanted steps are produced at the semiconductor substrate between the region where the selective growth is carried out and the masked region. These steps make the subsequent process unstable.

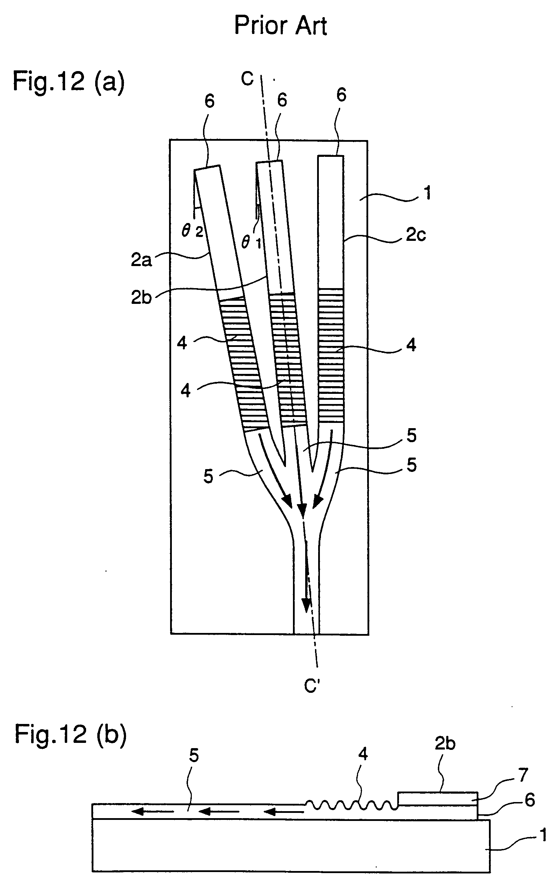

The above-described problems are prevented in a semiconductor laser device disclosed in Japanese Published Patent Application No. Sho. 58-48981. Figure 12(a) is a plan view illustrating the semiconductor laser device and figure 12(b) is a cross-sectional view taken along a line C-C' in figure 12(a). In these figures, the same reference numerals as those in figure 10 designate the same or corresponding parts. Reference numeral 7 designates an active layer. In this prior art semiconductor laser device, light beams emitted from the semiconductor laser elements 2a, 2b, and 2c are concentrated in a single waveguide by the waveguides 5, whereby the wavelengths of the laser beams are multiplexed. The diffraction gratings 4 are formed at the same period $\Lambda$ and in the same direction, and the wavelength controlled semiconductor laser elements 2a, 2b, and 2c are formed in different directions that make different angles $\theta$ with the direction perpendicular to the direction of the diffraction gratings 4. More specifically, as shown in figure 12(a), these angles $\theta$ are zero, $\theta_1$, and $\theta_2$ in the laser elements 2a, 2b, and 2c, respectively, and have a relationship of $0 < \theta_1 < \theta_2$. Therefore, the periods of the diffraction gratings 4 in the center axis directions of the laser elements 2a, 2b, and 2c become $\Lambda$, $\Lambda/\cos\theta_1$, and $\Lambda/\cos\theta_2$, respectively. According to the periods of the diffraction gratings, the wavelengths of the light beams oscillated in the laser elements 2a, 2b, and 2c become $\lambda_0$, $\lambda_0/\cos\theta_1$, and $\lambda_0/\cos\theta_2$, respectively, when $\lambda_0 = 2n\Lambda$ from the formula (1). That is, by changing the angles of the center axes of the respective semiconductor laser elements 2a, 2b, and 2c to the diffraction gratings 4 that are produced at the same period and in the same direction, the wavelengths of the light beams oscillated in the respective laser elements are varied from each other. Actually, the minimum value for the difference in periods of the diffraction gratings of the DFB semiconductor laser elements used for the wavelength division multiplex optical communications is about 0.15 nm as described above, and the difference in the above-described angles $\theta$ corresponding to this minimum value is about 2.2°, which is a realizable value. Accordingly, in this prior art semiconductor laser device, since it is not necessary to change the period of the diffraction grating for each laser element, the fabricating process is simplified.

However, when the above-described refractive index coupled diffraction grating is applied to the prior art semiconductor laser device shown in figure 12, since the diffraction gratings are produced uniformly at the same period and no $\lambda/4$ shifted regions are produced in the center of the resonators, the oscillation of laser light in each semiconductor laser element is adversely affected by the phase change of the light due to reflections at the front and rear facets of the resonator, and the probability that each laser element oscillates in single mode, i.e., single wavelength, is reduced to about 70 %. Therefore, the probability that all of the laser elements included in the semiconductor laser device oscillate in single mode is $0.7^N$ (N = number of the laser elements). With an increase in the number of the laser elements, the probability of the single mode oscillation is decreased. Therefore, so long as the refractive index coupled diffraction grating having no $\lambda/4$ shifted region is used, a semiconductor laser device in which all laser elements oscillate in single mode cannot be obtained at good yield.

Further, in the prior art semiconductor laser device shown in figure 12, since the optical waveguides 5 connected to the respective laser elements have bent portions before reaching the junction, unwanted dissipation of light occurs in the bent portion.

## SUMMARY OF THE INVENTION

An object of the present invention is to provide a semiconductor laser device including a plurality of DFB semiconductor laser elements disposed on a semiconductor substrate and oscillating light beams of different wavelengths in a single mode with high stability.

Another object of the present invention is to provide a method of fabricating the semiconductor laser device.

Other objects and advantages of the invention will become apparent from the detailed description that follows. The detailed description and specific embodiments described are provided only for illustration since various additions and modifications within the scope of the invention will be apparent to those of skill in the art from the detailed description.

According to a first aspect of the present invention, a semiconductor laser device comprises a plurality of distributed feedback semiconductor laser elements disposed on a semiconductor substrate and each including a resonator having a center axis and a gain-coupled diffraction grating, wherein the gain-coupled diffraction gratings are arranged at the same period and in the same direction, and the center axes of the resonators form different angles with the direction perpendicular to the direction of the diffraction gratings. Therefore, the wavelengths of light beams oscillated in the respective semiconductor laser elements are varied from each other. Further, even when the diffraction grating with no $\lambda/4$-shifted region is employed, the oscillation of laser light in each semiconductor laser element is not adversely affected by the phase change of the laser light due to reflections at the front and rear facets of the resonator, so that a stable single-mode oscillation is easily realized.

According to a second aspect of the present invention, a semiconductor laser device comprises a plurality of distributed feedback semiconductor laser elements disposed on a semiconductor substrate and each including a resonator having a center axis and a refractive index coupled diffraction grating, wherein the refractive index coupled diffraction gratings are arranged at the same period and in the same direction, and the center axes of the resonators form different angles with the direction perpendicular to the direction of the diffraction gratings. Further, each refractive index coupled diffraction grating comprises first and second parts with the boundary in the center of the resonator, the grating direction and the grating period are identical in the first and second parts, and the phase of the first part is shifted from the phase of the second part by 1/2 of the grating period. Therefore, the wavelengths of light beams oscillated in the respective semiconductor laser elements are varied from each other. Further, since the diffraction grating having the $\lambda/4$-shifted region is employed, the oscillation of laser light in each semiconductor laser element is not adversely affected by the phase change of the laser light due to reflections at the front and rear facets of the resonator, so that a stable single-mode oscillation is easily realized.

According to a third aspect of the present invention, the above-described semiconductor laser device further includes a plurality of optical waveguides, each optical waveguide being connected to an end surface of the resonator of each semiconductor laser element, having a center axis identical to the center axis of the resonator, and extending straight from the end surface of the resonator to a position where the optical waveguide joins the optical waveguides connected to the other semiconductor laser elements. In this structure, since the optical waveguides have no bent portions from the semiconductor laser elements to the junction of the optical waveguides, the dissipation of light in the waveguides is reduced.

According to a fourth aspect of the present invention, a method of fabricating a semiconductor laser device comprises preparing a semiconductor substrate having opposite front and rear surfaces; successively growing an active layer comprising a first semiconductor having a first band gap energy and oscillating laser light, a first intermediate layer comprising a second semiconductor having a second band gap energy larger than the first band gap energy, and a diffraction grating layer comprising a third semiconductor having a third band gap energy smaller than the first band gap energy, over the front surface of the semiconductor substrate; forming a plurality of stripe-shaped resist films having a prescribed period on the surface of the diffraction grating layer; using the resist films as masks, etching the diffraction grating layer until the first intermediate layer is exposed, leaving stripe-shaped portions of the diffraction grating layer; after removal of the resist films, growing a second intermediate layer comprising the second semiconductor over the entire surface to bury the stripe-shaped portions of the diffraction grating layer within the semiconductor layer comprising the first and second intermediate layers, thereby producing a gain-coupled diffraction grating having the prescribed period and comprising the stripe-shaped portions of the diffraction grating layer; forming a plurality of etching masks on the second intermediate layer, the etching masks comprising insulating films and extending in directions that form different angles with the direction perpendicular to the grating direction of the diffraction grating; using the etching masks, etching the second intermediate layer, the diffraction grating, the first intermediate layer, and the active layer until the semiconductor substrate is exposed, thereby producing a plurality of resonators comprising the semiconductor layers remaining under the etching masks; selectively growing a current blocking layer on the semiconductor substrate to fill spaces produced by the etching of the semiconductor layers; after removal of the etching masks, growing a contact layer over the entire surface; etching portions of the contact layer and the current blocking layer in prescribed regions between the resonators until the semiconductor substrate is exposed, thereby producing grooves for electrically separating the resonators from each other; and producing a surface electrode that makes an ohmic contact with the contact layer on the surface of the contact layer and producing a rear electrode that makes an ohmic contact with the semiconductor substrate on the rear surface of the semiconductor substrate, thereby completing a plurality of semiconductor laser elements each having a resonator. In this method, there is no necessity of forming $\lambda/4$-shifted regions in the diffraction gratings, and the diffraction gratings are uniformly fabricated at the same period. Therefore, the fabricating process of the diffraction gratings is facilitated, thereby improving the yield and the reliability of the semiconductor laser device. Further, in the semiconductor laser device fabricated in this method, the wavelengths of light beams oscillated in the respective semiconductor laser elements are varied from each other, and the laser oscillation in each semiconductor laser element is not adversely affected by the phase change of the laser light due to reflections at the front and rear facets of the resonator, whereby a stable single-mode oscillation is easily realized.

According to a fifth aspect of the present invention, a method of fabricating a semiconductor laser device comprises preparing a semiconductor substrate having opposite front and rear surfaces; successively growing an active layer comprising a first semiconductor having a first band gap energy and oscillating laser light, a first intermediate layer comprising a second semiconductor having a second band gap energy larger than the first band gap energy and a first refractive index, and a diffraction grating layer comprising a third semiconductor having a second refractive index different from the first refractive index, over the front surface of the semiconductor substrate; forming a resist pattern comprising a plurality of stripes having a prescribed period on the surface of the diffraction grating layer, the resist pattern comprising a first portion and a second portion with a boundary that is extended in the same direction as the direction of the stripes and located in the center of the resist pattern, the direction of the stripes and the period of the stripes are identical in the first and second portions, and the phase of the first portion being shifted from the phase of the second portion by 1/2 of the period of the stripes; using the resist pattern as a mask, etching the diffraction grating layer until the first intermediate layer is exposed, leaving stripe-shaped portions of the diffraction grating layer; after removal of the resist pattern, growing a second intermediate layer comprising the second semiconductor over the entire surface to bury the stripe-shaped portions of the diffraction grating layer within the semiconductor layer comprising the first and second intermediate layers, thereby producing a refractive index coupled diffraction grating having the prescribed period and comprising the stripe-shaped portions of the diffraction grating layer; forming a plurality of etching masks on the second intermediate layer, the etching masks comprising insulating films and extending in directions that form different angles with the direction perpendicular to the grating direction of the diffraction grating; using the etching masks, etching the second intermediate layer, the diffraction grating, the first intermediate layer, and the active layer until the semiconductor substrate is exposed, thereby producing a plurality of resonators comprising the semiconductor layers remaining under the etching masks; selectively growing a current blocking layer on the semiconductor substrate to fill spaces produced by the etching of the semiconductor layers; after removal of the etching masks, growing a contact layer over the entire surface; etching portions of the contact layer and the current blocking layer in prescribed regions between the resonators until the semiconductor substrate is exposed, thereby producing grooves for electrically separating the resonators from each other; and producing a surface electrode that makes an ohmic contact with the contact layer on the surface of the contact layer and producing a rear electrode that makes an ohmic contact with the semiconductor substrate on the rear surface of the semiconductor substrate, thereby completing a plurality of semiconductor laser elements each having a resonator. In this method, since the diffraction gratings are uniformly fabricated at the same period, the fabricating process is facilitated, thereby improving the yield and the reliability of the semiconductor laser device. Further, in the semiconductor laser device fabricated in this method, the wavelengths of light beams oscillated in the respective semiconductor laser elements are varied from each other, and the laser oscillation in each semiconductor laser element is not adversely affected by the phase change of the laser light due to reflections at the front and rear facets of the resonator, whereby a stable single-mode oscillation is easily realized.

According to a sixth aspect of the present invention, the above-described method further includes producing a plurality of optical waveguides on the surface of the semiconductor substrate so that each optical waveguide is connected to an end surface of the resonator of each semiconductor laser element, has a center axis identical to the center axis of the resonator, and extends straight from the end surface of the resonator to a position where the optical waveguide joins the optical waveguides connected to the other semiconductor laser elements. In the semiconductor laser device fabricated in this method, since the optical waveguides have no bent portions from the semiconductor laser elements to the junction of the waveguides, the dissipation of light in the waveguides is reduced.

BRIEF DESCRIPTION OF THE DRAWINGS

Figure 1 is a plan view illustrating a semiconductor laser device in accordance with a first embodiment of the present invention.

Figure 2 is a cross-sectional view taken along a line A-A' in figure 1.

Figure 3 is an enlarged view of a part of the semiconductor laser device shown in figure 1.

Figures 4(a)-4(h) are diagrams illustrating process steps in a method of fabricating the semiconductor laser device shown in figure 1, wherein figures 4(a)-4(d) and 4(f)-4(h) are cross-sectional views and figure 4(e) is a plan view.

Figures 5(a) and 5(b) are schematic diagrams for explaining an EB printing pattern which is used in formation of a photomask for forming etching masks used in fabrication of resonators.

Figure 6 is a cross-sectional view illustrating a semiconductor laser device in accordance with a second embodiment of the present invention.

Figures 7(a) and 7(b) are cross-sectional views illustrating process steps in a method of fabricating the semiconductor laser device shown in figure 6.

Figure 8 is a plan view illustrating a semiconductor laser device in accordance with a third embodiment of the present invention.

Figure 9 is a plan view illustrating a process step in a method of fabricating the semiconductor laser device shown in figure 8.

Figure 10 is a plan view illustrating a semiconductor laser device comprising a plurality of laser elements in which resonators of the respective laser elements have diffraction gratings of different periods, according to the prior art.

Figure 11 is a plan view illustrating a semiconductor laser device in which a resonator has a bent portion in place of a $\lambda/4$-shifted region of a diffraction grating, according to the prior art.

Figures 12(a) and 12(b) are diagrams illustrating a semiconductor laser device including a plurality of semiconductor laser elements which are disposed in different directions with respect to a diffraction grating which is produced at the same period and in the same direction according to the prior art, wherein figure 12(a) is a plan view of the laser device and figure 12(b) is a cross-sectional view taken along a line C-C' in figure 12(a).

## DETAILED DESCRIPTION OF THE PREFERRED EMBODIMENTS

[Embodiment 1]

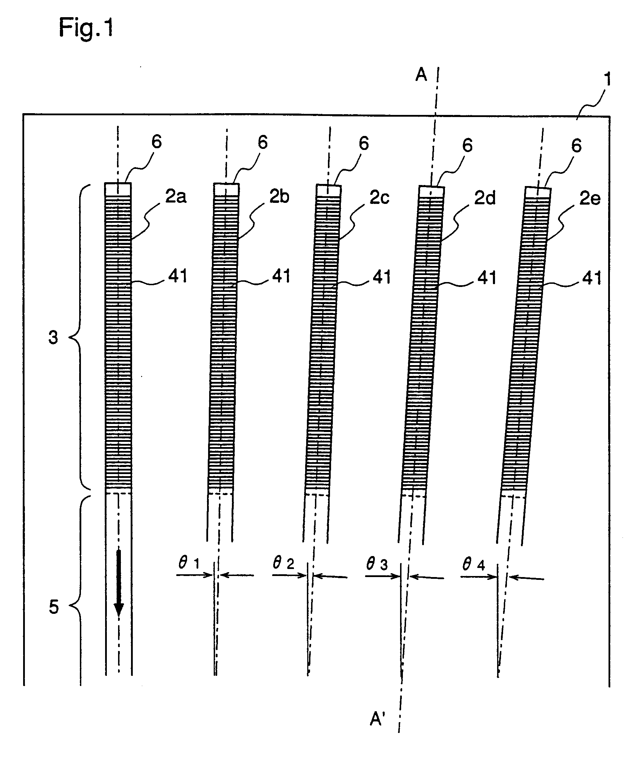

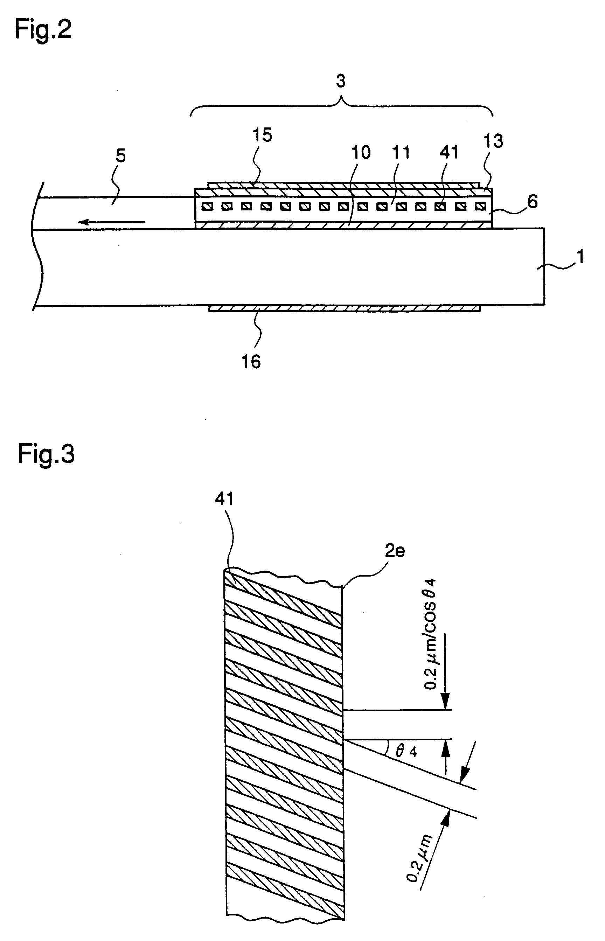

Figure 1 is a plan view illustrating a semiconductor laser device in accordance with a first embodiment of the present invention. In the figure, reference numeral 1 designates a semiconductor substrate, numerals 2a, 2b, 2c, 2d, and 2e (hereinafter referred to as 2a to 2e) designate semiconductor laser elements, numeral 3 designates resonators, numeral 41 designates gain-coupled diffraction gratings, numeral 5 designate waveguides, and numeral 6 designate rear facets of the resonators. The semiconductor laser elements 2a to 2e are DFB (distributed feedback) lasers each having a resonator 3 with a gain-coupled diffraction grating 41. The alternate long and short dash line shows the center axis of the resonator 3 of the semiconductor laser element, and the arrow shows the light traveling direction. The gain-coupled diffraction gratings 41 are formed uniformly at the same period of 0.2 $\mu$m and in the same direction. The DFB semiconductor laser elements 2a to 2e are formed so that the center axis directions of the resonators 3 make different angles $\theta$ with the direction perpendicular to the direction of the diffraction gratings 41. As shown in figure 1, these angles $\theta$ are zero, $\theta_1$, $\theta_2$, $\theta_3$, and $\theta_4$ in the laser elements 2a, 2b, 2c, 2d, and 2e, respectively, and have a relationship of $0 < \theta_1 < \theta_2 < \theta_3 < \theta_4$. Figure 2 is a cross-sectional view of the laser device taken along a line A-A' in figure 1. In figure 2, an active layer 10, an intermediate layer 11, and a contact layer 13 are disposed on the front surface of the semiconductor substrate 1 in this order, and the diffraction grating 41 that is formed uniformly at the same period is buried in the intermediate layer 11. A surface electrode 15 is disposed on the contact layer 13 and a rear electrode 16 is disposed on the rear surface of the semiconductor substrate 1. The diffraction grating 41 comprises a material having a band gap energy smaller than the band gap energy of the active layer 10 so that light produced in the active layer is absorbed by the diffraction grating 41. That is, the diffraction grating 41 is of gain-coupled type. Figure 3 is an enlarged view of a part of the resonator 3 of the semiconductor laser element 2e. As shown in figure 3, the period of the diffraction grating 41 to light traveling in the center axis direction of the resonator of the semiconductor laser element 2e is $(0.2/\cos\theta_4)\mu$m . Likewise, the periods of the diffraction gratings in the center axis directions of the laser elements 2a, 2b, 2c, and 2d are 0.2 $\mu$m, $(0.2/\cos\theta_1)\mu$m , $(0.2/\cos\theta_2)\mu$m, and $(0.2/\cos\theta_3)\mu$m, respectively. According to these periods of the diffraction gratings, the wavelengths of light beams oscillated in the laser elements 2a, 2b, 2c, 2d, and 2e are, when the oscillation wavelength at $\theta = 0$ is $\lambda_0$, $\lambda_0$, $\lambda_0/\cos\theta_1$, $\lambda_0/\cos\theta_2$, $\lambda_0/\cos\theta_3$, $\lambda_0/\cos\theta_4$, respectively, from the formula (1).

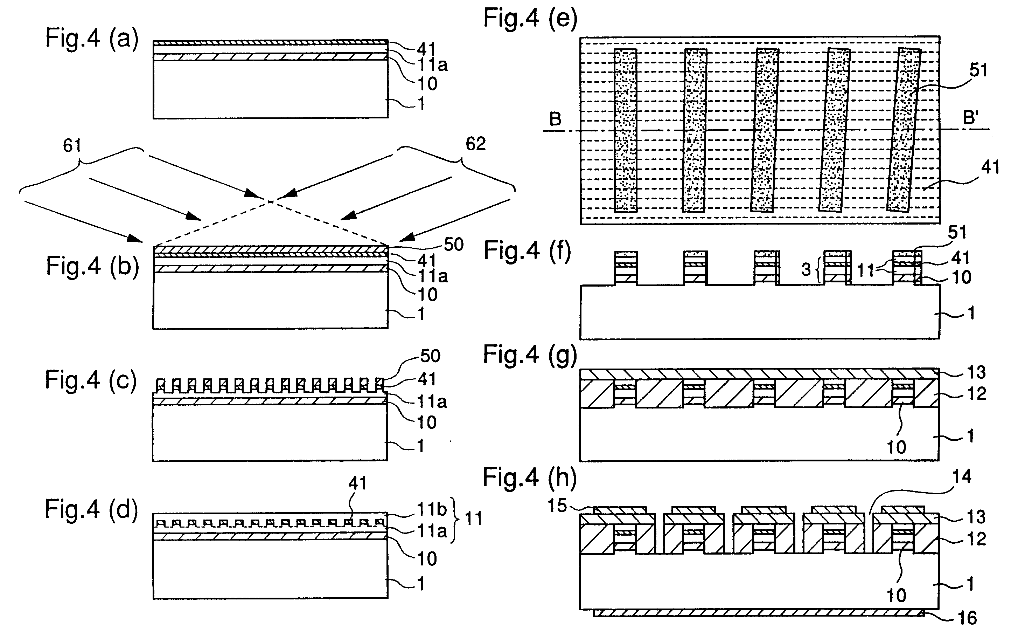

Figures 4(a)-4(h) are diagrams illustrating process steps in a method of fabricating the semiconductor laser device shown in figure 1, wherein figures 4(a)-4(d) and 4(f)-4(h) are cross-sectional views and figure 4(e) is a plan view.

Initially, as illustrated in figure 4(a), an active layer 10, a first intermediate layer 11a, a gain-coupled diffraction grating layer 41 are successively grown over the entire surface of the semiconductor substrate 1. The first intermediate layer 11a comprises a semiconductor having a band gap energy larger than that of a semiconductor constituting the active layer 10. The gain-coupled diffraction grating layer 41 comprises a semiconductor having a band gap energy smaller than that of the semiconductor constituting the active layer 10, so that light produced in the active layer is absorbed by the diffraction grating layer 41.

In the step of figure 4(b), a resist 50 is deposited over the entire surface, and the resist 50 is irradiated with monochromatic light beams 61 and 62 having uniform phase using interference exposure method. In the interference exposure process, the light intensity on the resist 50 periodically varies in different positions due to the interference of the light beams 61 and 62. Therefore, when the resist 50 is developed, portions of the resist 50 are periodically left on the diffraction grating layer 41. This period is determined by the wavelengths of the monochromatic light beams 61 and 62, and the periodic resist pattern formed by the light beams is as fine as about the half of the resolution limit of ordinary photolithographic technique in which a light is applied to a resist through a photomask.

In the step of figure 4(c), using the periodic resist pattern 50 as a mask, the gain-coupled diffraction grating layer 41 and the first intermediate layer 11a are etched, leaving a prescribed thickness of the first intermediate layer 11a. As a result of the etching, a gain-coupled diffraction grating 41 having a regular period is produced.

After removal of the resist pattern 50, as illustrated in figure 4(d), a second intermediate layer 11b comprising the same semiconductor as the first intermediate layer 11a is grown over the entire surface to bury the gain-coupled diffraction grating 41 within the intermediate layer 11 comprising the first and second intermediate layers.

In the step of figure 4(e), etching masks 51 are formed on the surface of the intermediate layer 11 in regions where resonators of semiconductor laser elements are later produced. In figure 4(e), the dashed lines show the diffraction grating 41. The etching masks 51 are formed so that the directions of the center axes of the etching masks make different angles with the direction perpendicular to the grating direction (shown by the dashed lines) of the diffraction grating 41 which is formed uniformly at the same period and in the same direction.

Thereafter, as illustrated in figure 4(f), using the etching masks 51, the intermediate layer 11, the gain-coupled diffraction grating 41, and the active layer 10 are etched until the semiconductor substrate 1 is exposed, thereby producing stripe-shaped resonators 3 comprising the semiconductor layers left under the etching masks 51. Figures 4(f), 4(g), and 4(h) are cross-sectional views taken along a line B-B' in figure 4(e).

In the step of figure 4(g), a current blocking layer 12 is grown on the semiconductor substrate 1 to fill the spaces produced in the above-described etching process. After removal of the etching masks 51 by etching, a contact layer 13 is grown over the entire surface.

In the step of figure 4(h), grooves 14 for electrically separating the semiconductor laser elements from each other are formed by etching. Finally, a surface electrode 15 that makes an ohmic contact with the contact layer 13 is fabricated on the contact layer 13 of each laser element, and a rear electrode 16 that makes an ohmic contact with the semiconductor substrate 1 is fabricated on the rear surface of the semiconductor substrate. In this way, a semiconductor laser device comprising a plurality of DFB semiconductor laser elements in which the center axis directions of the resonators of the DFB laser elements make different angles with the direction perpendicular to the grating direction of the diffraction gratings 41 is fabricated.

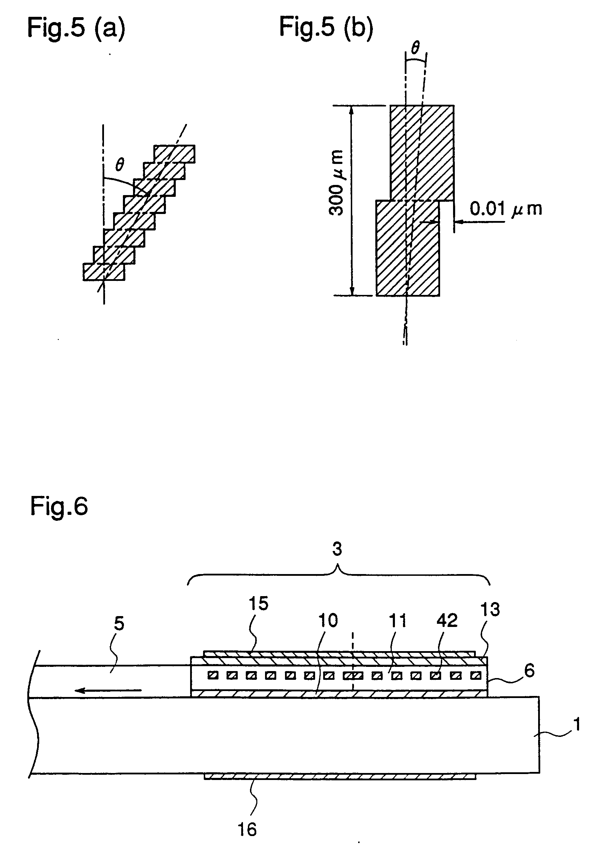

In this first embodiment of the present invention, since the center axes of the respective semiconductor laser elements 2a to 2e make different angles with the direction perpendicular to the gain-coupled diffraction grating 41 which is formed uniformly at the same period and in the same direction, the wavelengths of light beams oscillated in the respective laser elements are varied from each other. As described above, an appropriate value for the minimum difference between different two wavelengths in the wavelength division multiplex optical communication system is about 1 nm. When the active layer comprises InGaAsP, since the refractive index n is equal to 3.400, the difference in the periods of the diffraction gratings that corresponds to the above-described difference in the wavelengths becomes 0.15 nm from the formula (1). Further, the difference in the angles produced between the center axes of the resonators and the grating direction of the diffraction gratings which corresponds to the difference in the periods becomes about 2.2° in the case where the diffraction gratings 41 are formed at the same period of 0.2μm as in this first embodiment, and this value, i.e., 2.2°, is realizable. A minimum value for this angle depends on a photomask used in a photolithographic process for forming the etching masks 51 used in the formation of the resonators. Usually, this photomask is formed using an ordinary EB printing apparatus. In the EB printing apparatus, a rectangular unit region is irradiated with an electron beam. So, when a pattern inclined at an angle to a specific direction, like the above-described resonator, is printed, the rectangular printed region is gradually shifted as shown in figure 5(a). In figure 5(a), the alternate long and short dash line shows the center axis of the resonator, and the alternate long and two short dashes line shows the direction perpendicular to the grating direction of the diffraction grating 41, and θ shows an angle produced between the center axis and the direction perpendicular to the grating direction. In the EB printing apparatus, a minimum value for the distance of shifting the rectangular printed region is about 0.01 μm. In this first embodiment, when the length of the resonator is 300 μm, a minimum value for the angle θ of the resonator that is formed using the ordinary EB printing apparatus is realized with the pattern of the EB printed region shown in figure 5(b), and it is $\mathrm{Tan}^{-1}(0.01/300) = 0.0019°$. This angle is sufficiently smaller than the above-described 2.2°. Since the period of the diffraction grating 41 is 0.2 μm, the period of the diffraction grating in the center axis direction of the resonator is given by

$$0.2/\cos(\mathrm{Tan}^{-1}(0.01/300)) = 0.20000000011 \ \mu m$$

A difference between this period, i.e., 0.20000000011 μm, and the period of the diffraction grating of the resonator having 0° for the angle θ, i.e., 0.2 μm, is 0.00000011 nm, and this is a minimum value for the difference in the periods of the diffraction gratings. In the prior art method of changing the period of the diffraction grating for each semiconductor laser element, even when the diffraction grating is formed using a specially remodeled EB printing apparatus, a minimum value for the available difference in the periods of the diffraction gratings is 0.05 nm because of the restriction of the apparatus. However, in the method according to this first embodiment of the invention, even when the photomask for forming the etching masks 51 is produced using an ordinary EB printing apparatus that is not remodeled as described above, the above-described very small minimum value is realized for the difference in the periods of the diffraction gratings.

As described above, in this first embodiment of the invention, the wavelengths of light beams oscillated in the respective laser elements 2a to 2e are varied from each other. In addition, since the diffraction grating 41 is of gain-coupled type, even when no λ/4-shifted region is produced in the diffraction grating, a stable single mode oscillation is realized in each semiconductor laser element. Further, since it is not necessary to produce the λ/4-shifted region of the diffraction grating in the center of the resonator, a general pattern transfer technique, such as above-described interference exposure method, can be applied to the formation of the diffraction grating. In this case, the time required for the exposure is significantly reduced as compared to the case where EB direct printing method is applied. In addition, since the processing is very simple and highly reliable, the production yield is improved. As a result, the reliability of the semiconductor laser device is improved.

The EB direct printing method may be employed for the formation of the diffraction grating. In this case, although the printing time is longer than the exposure time in the interference exposure method, it is shorter than the printing time of the prior art EB printing method in which the diffraction gratings of the respective laser elements are produced at different periods. Further, the printing operation is simplified compared to the prior art method because the process of producing the plural job files corresponding to the resonators is dispensed with.

[Embodiment 2]

A semiconductor laser device according to a second embodiment of the present invention comprises a plurality of DFB semiconductor laser elements disposed on a semiconductor substrate and having resonators with refractive index coupled diffraction gratings which are uniformly formed at the same period and in the same direction, and angles produced between the center axes of the resonators of the respective laser elements and the direction perpendicular to the diffraction grating direction are varied from each other. The arrangements of the DFB laser elements and the diffraction gratings are identical to those of the semiconductor laser device according to the first embodiment shown in figure 1. Figure 6 is a cross-sectional view of the semiconductor laser device according to this second embodiment. In figure 6, an active layer 10, an intermediate layer 11, and a contact layer 13 are disposed on the semiconductor substrate 1 in this order, and a diffraction grating 42 is buried in the intermediate layer 11. A surface electrode 15 is disposed on the contact layer 13, and a rear electrode 16 is disposed on the rear surface of the semiconductor substrate 1. The diffraction grating 42 comprises a material having a refractive index different from that of a material constituting the intermediate layer 11, that is, the diffraction grating 42 is of refractive index coupled type. In addition, the phase of the diffraction grating 42 is shifted in the center of the resonator 3 by π, i.e., by 1/2 of the period of the diffraction grating. The phase-shifted position is indicated by the dotted line in figure 6. This position corresponds to the above-mentioned λ/4-shifted region.

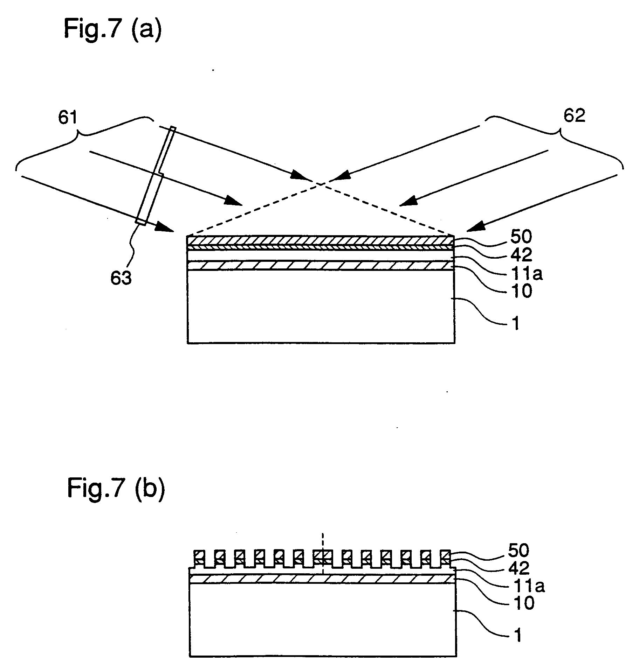

Figures 7(a) and 7(b) are cross-sectional views illustrating process steps in a method of fabricating the semiconductor laser device shown in figure 6.

Initially, an active layer 10, a first intermediate layer 11a, and a refractive index coupled diffraction grating layer 42 are successively grown on the entire surface of the semiconductor substrate 1. The first intermediate layer 11a comprises a semiconductor having a band gap energy larger than that of a semiconductor constituting the active layer 10. The refractive index coupled diffraction grating layer 42 comprises a semiconductor having a refractive index different from that of the semiconductor constituting the intermediate layer.

Thereafter, as illustrated in figure 7(a), a resist 50 is deposited over the entire surface, and the resist 50 is irradiated with two monochromatic light beams 61 and 62 having uniform phase, using interference exposure method with phase shifting technique. The monochromatic light beam 61 is applied through a phase shifter 63 to the resist 50, whereby the phase of the monochromatic light beam 61 on the surface of the resist 50 is shifted between the right and left side regions from the center of the resist. Thereby, the phase of the periodic change of the light intensity on the surface of the resist 50 due to the interference of the light beams 61 and 62 is shifted by π with the center of the resist as a boundary.

After exposure and developing of the resist 50, the refractive index coupled diffraction grating layer 42 and the first intermediate layer 11a are etched using the resist as a mask, producing a refractive index coupled diffraction grating 42 having a λ/4-shifted region (figure 7(b)). A prescribed thickness of the first intermediate layer 11a is left on the active layer 10. The process steps after the formation of the diffraction grating 42 are identical to those already described with respect to figures 4(d)-4(h). That is, a second intermediate layer 11b is grown to bury the refractive index coupled diffraction grating 42 within the intermediate layer 11 comprising the first and second intermediate layers 11a and 11b, followed by formation of resonators of semiconductor laser elements. Thereafter, a current blocking layer 12 and a contact layer 13 are grown, and grooves 14 for electrically separating the semiconductor laser elements from each other are produced. Finally, a surface electrode 15 is formed on the contact layer 13 of each laser element, and a rear electrode 16 is formed on the rear surface of the substrate 1. In this way, a semiconductor laser device comprising a plurality of DFB semiconductor laser elements in which the center axes of the resonators of the laser elements make different angles with the direction perpendicular to the grating direction of the refractive index coupled diffraction gratings 42 is completed.

Also in this second embodiment of the invention, since the center axes of the respective semiconductor laser elements make different angles with the diffraction gratings 42 which are produced at the same period and in the same direction, the wavelengths of light beams oscillated in the respective laser elements are varied from each other. In addition, since the diffraction grating 42 is of refractive index coupled type and has the λ/4-shifted region in the center of the resonator, adverse influences of reflections at the front and rear facets of the resonator are reduced, whereby the oscillation of laser light in each semiconductor laser element is made a stable single-mode oscillation.

Further, in this second embodiment, since the diffraction grating having the λ/4-shifted region is produced using the interference exposure method with phase shifting technique, the time required for the exposure is significantly reduced as compared to the case where the diffraction grating is produced by the EB direct printing method. In addition, since the processing is very simple and highly reliable, the production yield is improved. As a result, the reliability of the semiconductor laser device is improved.

The EB direct printing method may be employed for the formation of the diffraction grating. In this case, although the printing time is longer than the exposure time of the interference exposure method, it is shorter than the printing time of the prior art EB printing method in which the diffraction gratings of the respective laser elements are produced at different periods. Further, the printing operation is simplified compared to the prior art method.

Alternatively, the diffraction grating may be formed by an interference exposure method using positive and negative resists simultaneously. Also in this case, a similar diffraction grating having a λ/4-shifted region as that produced by the above-described phase shifting interference exposure method is obtained.

[Embodiment 3]

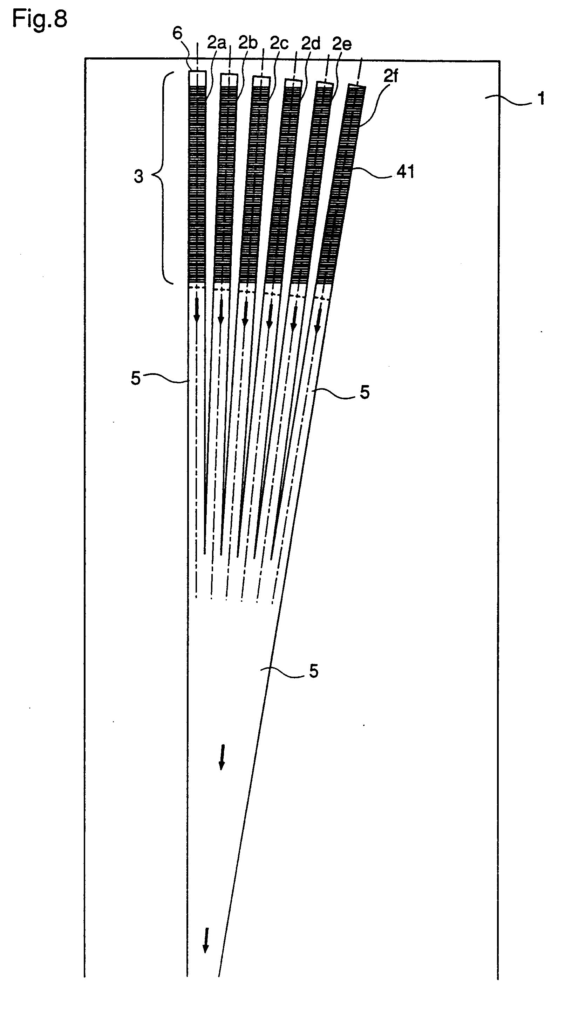

Figure 8 is a plan view illustrating a semiconductor laser device in accordance with a third embodiment of the present invention. This laser device comprises similar DFB semiconductor laser elements 2a, 2b, 2c, 2d, and 2e as those described in the first or second embodiment of the invention, and optical waveguides 5 connected to the laser light emitting side of resonators 3 of the respective laser elements. The optical waveguides 5 are extended straight along the center axes of the respective resonators and combined to form a single waveguide.

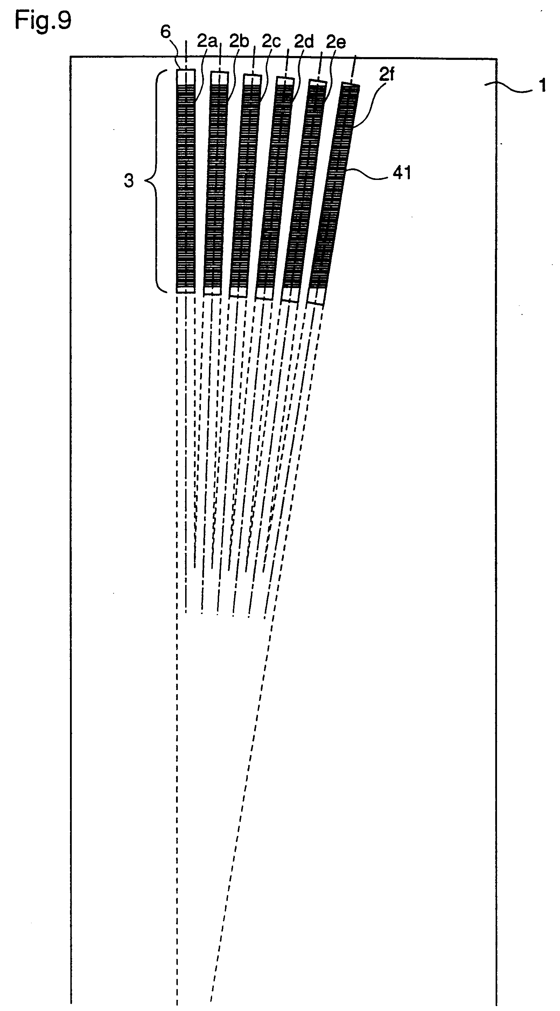

Figure 9 is a plan view for explaining a method of fabricating the semiconductor laser device shown in figure 8. After fabricating the DFB semiconductor laser elements 2a to 2e in the process steps already described in the first or second embodiment of the invention, a semiconductor layer for the optical waveguides 5 is formed in the region shown by the dashed lines in figure 9.

In this third embodiment of the invention, since the center axes of the resonators 3 of the respective semiconductor laser elements 2a to 2e are all in different directions, the optical waveguides 5 connected to the respective laser elements are easily combined by extending these waveguides 5 straight along the center axes of the resonators. In the prior art laser devices shown in figures 10 and 12, since the optical waveguides are bent to combine these waveguides, unwanted dissipation of laser light occurs in the bent portion. However, in the semiconductor laser device according to this third embodiment, since the optical waveguides have no bent portions, the dissipation of laser light in the optical waveguides is significantly reduced.

**Claims**

1. A semiconductor laser device (Figs.1 & 2) comprising:

   a semiconductor substrate (1) having a surface; and
   a plurality of distributed feedback semiconductor laser elements (2a,2b,2c,2d,2e) disposed on the surface of the semiconductor substrate (1), each semiconductor laser element including a resonator (3) having a center axis and a gain-coupled diffraction grating (41), wherein the gain-coupled diffraction gratings (41) are arranged at the same period and in the same direction, and the center axes of the resonators (3) form different angles with the direction perpendicular to the direction of the diffraction gratings (41).

2. A semiconductor laser device (Figs. 1 & 6) comprising:

   a semiconductor substrate (1) having a surface;
   a plurality of distributed feedback semiconductor laser elements (2a,2b,2c,2d,2e) disposed on the surface of the semiconductor substrate (1), each semiconductor laser element including a resonator (3) having a center axis and a refractive index coupled diffraction grating (41), wherein the refractive index coupled diffraction gratings (41) are arranged at the same period and in the same direction, and the center axes of the resonators (3) form different angles with the direction perpendicular to the direction of the diffraction gratings (41); and
   each refractive index coupled diffraction grating (41) comprising first and second parts with the boundary in the center of the resonator (3), the grating direction and the grating period being identical in the first and second parts, and the phase of the first part being shifted from the phase of the second part by 1/2 of the grating period.

3. The semiconductor laser device of claim 1 (Fig. 8) further including:

a plurality of optical waveguides (5), each optical waveguide being connected to an end surface of the resonator (3) of each semiconductor laser element, having a center axis identical to the center axis of the resonator (3), and extending straight from the end surface of the resonator (3) to a position where the optical waveguide (5) joins the optical waveguides (5) connected to the other semiconductor laser elements.

4. The semiconductor laser device of claim 2 (Fig. 8) further including:

a plurality of optical waveguides (5), each optical waveguide being connected to an end surface of the resonator (3) of each semiconductor laser element, having a center axis identical to the center axis of the resonator (3), and extending straight from the end surface of the resonator (3) to a position where the optical waveguide (5) joins the optical waveguides (5) connected to the other semiconductor laser elements.

5. A method of fabricating a semiconductor laser device (Figs. 4(a)-4(h)) comprising:

preparing a semiconductor substrate (1) having opposite front and rear surfaces;
successively growing an active layer (10) comprising a first semiconductor having a first band gap energy and oscillating laser light, a first intermediate layer (11a) comprising a second semiconductor having a second band gap energy larger than the first band gap energy, and a diffraction grating layer (41) comprising a third semiconductor having a third band gap energy smaller than the first band gap energy, over the front surface of the semiconductor substrate (1);
forming resist pattern comprising a plurality of stripes (50) having a prescribed period on the surface of the diffraction grating layer (41);
using the resist pattern (50) as a mask, etching the diffraction grating layer (41) until the first intermediate layer (11a) is exposed, leaving stripe-shaped portions of the diffraction grating layer (41);

after removal of the resist pattern (50), growing a second intermediate layer (11b) comprising the second semiconductor over the entire surface to bury the stripe-shaped portions of the diffraction grating layer (41) within the semiconductor layer (11) comprising the first and second intermediate layers (11a & 11b), thereby producing a gain-coupled diffraction grating comprising the stripe-shaped portions of the diffraction grating layer and having the perscribed period;
forming a plurality of etching masks (51) on the second intermediate layer (11b), said etching masks (51) comprising insulating films and extending in directions that form different angles with the direction perpendicular to the grating direction of the diffraction grating;
using the etching masks (51), etching the second intermediate layer (11b), the diffraction grating, the first intermediate layer (11a), and the active layer (10) until the semiconductor substrate (1) is exposed, thereby producing a plurality of resonators (3) comprising the semiconductor layers remaining under the etching masks (51);
selectively growing a current blocking layer (12) on the semiconductor substrate (1) to fill spaces produced by the etching of the semiconductor layers;
after removal of the etching masks (51), growing a contact layer (13) over the entire surface;
etching portions of the contact layer (13) and the current blocking layer (12) in prescribed regions between the resonators (3) until the semiconductor substrate (1) is exposed, thereby producing grooves (14) for electrically separating the resonators (3) from each other; and
producing a surface electrode (15) that makes an ohmic contact with the contact layer (13) on the surface of the contact layer (13) and producing a rear electrode (16) that makes an ohmic contact with the semiconductor substrate (1) on the rear surface of the semiconductor substrate (1), thereby completing a plurality of semiconductor laser elements (2a,2b,2c,2d,2e) each having a resonator (3).

6. A method of fabricating a semiconductor laser device (Figs. 7(a)-7(b)) comprising:

preparing a semiconductor substrate (1) having opposite front and rear surfaces;
successively growing an active layer (10) comprising a first semiconductor having a first band gap energy and oscillating laser light, a first intermediate layer (11a) comprising a second semiconductor having a second band gap energy larger than the first band gap energy and a first refractive index, and a diffraction grating layer (42) comprising a third semiconductor having a second refractive index different from the first refractive index, over the front surface of the semiconductor substrate (1);

forming a resist pattern comprising a plurality of stripes (50) having a prescribed period on the surface of the diffraction grating layer (41), said resist pattern (50) comprising a first portion and a second portion with a boundary that is extended in the same direction as the direction of the stripes and located in the center of the resist pattern (50), the direction of the stripes and the period of the stripes are identical in the first and second portions, and the phase of the first portion being shifted from the phase of the second portion by 1/2 of the period of the stripes;

using the resist pattern (50) as a mask, etching the diffraction grating layer (42) until the first intermediate layer (11a) is exposed, leaving stripe-shaped portions of the diffraction grating layer (42);

after removal of the resist pattern (50), growing a second intermediate layer (11b) comprising the second semiconductor over the entire surface to bury the stripe-shaped portions of the diffraction grating layer (42) within the semiconductor layer (11) comprising the first and second intermediate layers (11a & 11b), thereby producing a refractive index coupled diffraction grating comprising the stripe-shaped portions of the diffraction grating layer (42) and having the prescribed period;

forming a plurality of etching masks (51) on the second intermediate layer (11b), said etching masks (51) comprising insulating films and extending in directions that form different angles with the direction perpendicular to the grating direction of the diffraction grating;

using the etching masks (51), etching the second intermediate layer (11b), the diffraction grating, the first intermediate layer (11a), and the active layer (10) until the semiconductor substrate (1) is exposed, thereby producing a plurality of resonators (3) comprising the semiconductor layers remaining under the etching masks (51);

selectively growing a current blocking layer (12) on the semiconductor substrate (1) to fill spaces produced by the etching of the semiconductor layers;

after removal of the etching masks (51), growing a contact layer (13) over the entire surface;

etching portions of the contact layer (13) and the current blocking layer (12) in prescribed regions between the resonators (3) until the semiconductor substrate (1) is exposed, thereby producing grooves (14) for electrically separating the resonators (3) from each other; and

producing a surface electrode (15) that makes an ohmic contact with the contact layer (13) on the surface of the contact layer (13) and producing a rear electrode (16) that makes an ohmic contact with the semiconductor substrate (1) on the rear surface of the semiconductor substrate (1), thereby completing a plurality of semiconductor laser elements (2a,2b,2c,2d,2e) each having a resonator (3).

7. The method of claim 5 (Figs. 8 & 9) further including:

   producing a plurality of optical waveguides (5) on the surface of the semiconductor substrate (1), each optical waveguide (5) being connected to an end surface of the resonator (3) of each semiconductor laser element, having a center axis identical to the center axis of the resonator (3), and extending straight from the end surface of the resonator (3) to a position where the optical waveguide (5) joins the optical waveguides (5) connected to the other semiconductor laser elements.

8. The method of claim 6 (Figs. 8 & 9) further including:

   producing a plurality of optical waveguides (5) on the surface of the semiconductor substrate, each optical waveguide being connected to an end surface of the resonator (3) of each semiconductor laser element, having a center axis identical to the center axis of the resonator (3), and extending straight from the end surface of the resonator (3) to a position where the optical waveguide (5) joins the optical waveguides (5) connected to the other semiconductor laser elements.

EP 0 732 785 A1

## Fig.1

Fig.2

Fig.3

Fig.4 (a)

41
11a
10
1

61                    62

Fig.4 (b)

50
41
11a
10
1

Fig.4 (c)

50
41
11a
10
1

Fig.4 (d)

41

11b } 11
11a }
10
1

Fig.4 (e)

51

B ————————————————————— B'

41

Fig.4 (f)

51
41
3 { 11
10
1

Fig.4 (g)

13
12
1
10

Fig.4 (h)

15    14
13
12
1
10
16

EP 0 732 785 A1

14

## Fig.5 (a)

## Fig.5 (b)

300 μm

θ

0.01 μm

## Fig.6

3

5

15    10    11    42    13

6

1

16

Fig.7 (a)

Fig.7 (b)

EP 0 732 785 A1

Fig.8

6  2a  2b  2c  2d  2e

2f

3

41

5

5

5

5

17

Fig.9

Fig.10  Prior Art

Fig.11   Prior Art

## Prior Art

Fig.12 (a)

Fig.12 (b)

EP 0 732 785 A1

| European Patent Office | EUROPEAN SEARCH REPORT | Application Number EP 96 10 3093 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | IEEE PHOTONICS TECHNOLOGY LETTERS, vol. 5, no. 9, 1 September 1993, pages 978-980, XP000414160 TSANG W T ET AL: "CONTROL OF LASING WAVELENGTH IN DISTRIBUTED FEEDBACK LASERS BY ANGLING THE ACTIVE STRIPE WITH RESPECT TO THE GRATING" | 1 | H01S3/25 H01S3/085 |
| Y | * page 979, right-hand column * | 3 | |
| A | | 2,4-6 | |
| Y | US-A-4 309 667 (DI FORTE MARIE A ET AL) 5 January 1982 | 2-4 | |
| A | * the whole document * | 5-8 | |
| Y | OPTOELECTRONICS DEVICES AND TECHNOLOGIES, vol. 9, no. 2, June 1994, TOKYO  JP, pages 153-166, XP000455298 C-E. ZAH ET AL:  "Monolithic integrated multiwavelength laser arrays for WDM lightwave systems" | 2,4 | |
| A | * page 156, line 8 * | 4,6,8 | TECHNICAL FIELDS SEARCHED     (Int.Cl.6) |
| A | JOURNAL OF LIGHTWAVE TECHNOLOGY, vol. 7, no. 12, 1 December 1989, pages 2072-2077, XP000103650 TAKEMOTO A ET AL:  "1.3 UM DISTRIBUTED FEEDBACK LASER DIODE WITH A GRATING ACCURATELY CONTROLLED BY A NEW FABRICATION TECHNIQUE" * figure 6 * | 5-8 | H01S |
| A | PATENT ABSTRACTS OF JAPAN vol. 017, no. 466 (E-1421), 25 August 1993 & JP-A-05 110187 (MATSUSHITA ELECTRIC IND CO LTD), 30 April 1993, * abstract * | 5-8 | |

-/--

The present search report has been drawn up for all claims

| Place of search | Date of completion of the search | Examiner |
|---|---|---|
| THE HAGUE | 1 July 1996 | Claessen, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

22

**European Patent Office**

## EUROPEAN SEARCH REPORT

Application Number

EP 96 10 3093

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US-A-5 020 072 (ABE YUJI ET AL) 28 May 1991 <br> * figure 5 * <br> --- | 2,6 | |
| D,A | PATENT ABSTRACTS OF JAPAN <br> vol. 007, no. 136 (E-181), 14 June 1983 <br> & JP-A-58 048981 (KOGYO GIJUTSUIN;OTHERS: 0J), 23 March 1983, <br> * abstract * <br> ----- | 1-8 | |
| | | | TECHNICAL FIELDS SEARCHED (Int.Cl.6) |

The present search report has been drawn up for all claims

| Place of search | Date of completion of the search | Examiner |
|---|---|---|
| THE HAGUE | 1 July 1996 | Claessen, L |